# EUROPEAN PATENT APPLICATION

(11) **EP 2 592 741 A1**
(43) Date of publication of application: **15.05.2013**
(21) Application number: 11306459.6
(22) Date of filing: 09.11.2011
(51) Int. Cl.: H02M 3/156, H01L 27/06, H02J 7/00

(54) **Integrated circuit adapted to perform power path control in a mobile equipment**

(71) Applicant: ST-Ericsson SA, 1228 Plan-les-Ouates (CH)
(72) Inventor: Ladret, Daniel, 38250 LANS-EN-VERCORS (FR)
(74) Representative: Hirsch & Associés

(57) **Abstract**

Some embodiments of the invention concern an integrated circuit adapted to perform power path control in a mobile equipment, including connections to external equipment (10,70,80,90), one or more further switches (11,12) adapted to switch on or off one or more connections to external equipment (10,70), wherein said circuit further integrates one or more driving switches (41,42) of at least one DCDC buck converter (4), and wherein one side (13) of one driving switch (41) is connected both to one connection to external equipment (10) through a further switch (11) and to another connection to external equipment (70) directly or through a further switch (12).

## Description

### FIELD OF THE INVENTION

The invention relates to integrated circuits adapted to perform power path control in mobile equipment as well as mobile equipments including such integrated circuits.

### BACKGROUND OF THE INVENTION

This invention is related to the portable devices, so-called mobile devices. Today, to get the better efficiency between the size, the weight and the storage energy, the mobiles have been supplied mainly by the Li-ion or Li-polymer or Li-hybrid technologies.

The power path is implemented in different products for multi-cell battery, that is to say 2 or 3-cell or more cells battery, these current products have a linear power path controlled by the battery charger with external MOS. The system has a buck converter to supply properly the power management powering the processor.

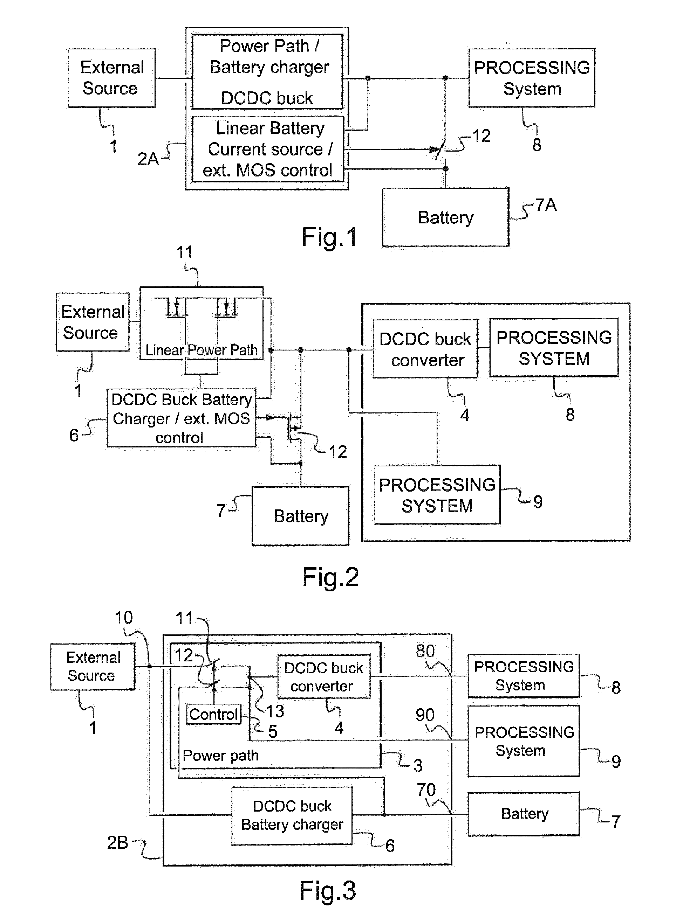

According to a first prior art, mobile equipment which is a mobile phone is described. Figure 1 shows the architecture of such mobile equipment. An external source 1 can be connected to mobile equipment. Mobile equipment includes an integrated circuit 2A. Integrated circuit 2A includes at least a first switch which is a part of a DCDC buck battery charger, and a switch controller controlling first switch. Switch controller also controls a second switch 12 external to integrated circuit 2A. Mobile equipment also includes a processing system 8 and a one cell battery 7A. When first internal switch is open and second external switch 12 is closed, processing system 8 is power alimented by battery 7A. When first internal switch is closed and second external switch 12 is open, processing system 8 is power alimented by external source 1 and battery 7A is charged by external source 1 through DCDC buck battery charger for high charging currents. At the node between first switch and driving switch of DCDC buck battery charger, there is no connection to another external connection external to integrated circuit 2A. Such architecture could not work with a multiple cell battery.

According to a second prior art, described in international application W02005022737, it is known to integrate part of several cascaded DCDC buck converters on a same printer circuit board. But this architecture using only one external power alimentation source (Vin on figure 2), it could not be used with a mobile equipment requiring commuting between two different power alimentation sources, as for example commuting between an external power alimentation source and an internal battery.

According to a third prior art, mobile equipment which is a laptop is described. Figure 2 shows the architecture of such mobile equipment. An external source 1 can be connected to mobile equipment. Mobile equipment includes a linear power path comprising a switch 11, a DCDC buck battery charger 6 assuming the function of a switch controller controlling switch 11 of power path. DCDC buck battery charger 6 also controls another switch 12. Mobile equipment also includes a first processing system 8, a second processing system 9, a DCDC buck converter 4, and a multiple cell battery 7. When switch 11 is open and switch 12 is closed, processing system 8 is power alimented by battery 7 through DCDC buck converter 4. When switch 11 is closed and switch 12 is open, processing system 8 is power alimented by external source 1 through DCDC buck converter 4, and battery 7 is charged by external source 1 through DCDC buck battery charger 6. One drawback of such architecture is the important size it occupies, because of the high number of standalone components.

### SUMMARY OF THE INVENTION

The object of the present invention is to alleviate at least partly the above mentioned drawbacks.

More particularly, the invention aims to provide a mobile equipment whose architecture offers about the same power alimentation flexibility as in third prior art, contrary to first and second prior arts whose power alimentation flexibility is poor, while presenting a notably higher component integration level than third prior art. Then the size of mobile equipment can be smaller while offering high power alimentation flexibility.

According to some embodiments of the invention, to reach this improved compromise between power alimentation flexibility and component integration level, one or more or all alimentation switches, whose function is to enable switching between different power alimentation sources, are integrated on the same integrated circuit than driving switches, whose function is to drive the self and the capacitor of a DCDC buck converter. In a preferred option, self and capacitor themselves are not integrated on this integrated circuit, but remain as standalone components, because their size is large compared to the size of alimentation switches and driving switches, and because their dissipated power may be difficult to manage on a single integrated circuit.

According to some embodiments of the invention, mobile equipment architecture uses a DCDC buck converter partly integrated with an alimentation switch to get a DCDC power path. This enables to reduce the number of standalone components in mobile equipment. Global efficiency of the overall mobile equipment is improved that way.

A first object of the invention is achieved with an integrated circuit adapted to perform power path control in a mobile equipment, integrating external connections, one or more alimentation switches adapted to switch on or off one or more external connections, wherein said printer circuit board further integrates one or more driving switches of at least one DCDC buck converter, and wherein one side of one driving switch is connected both to one external connection through an alimentation switch and to another external connection directly or through an alimentation switch.

A second object of the invention is achieved with an integrated circuit adapted to perform power path control in a mobile equipment, integrating a first external connection, a second external connection, a third external connection, a first alimentation switch, two driving switches of a DCDC buck converter, the first alimentation switch and first driving switch being successively connected in series between first external connection and second external connection, second driving switch being connected between first driving switch and third external connection, the first driving switch being connected to first alimentation switch without any self in between and being connected to a fourth external connection directly or through an alimentation switch.

Preferred embodiments comprise one or more of the following features:
- several alimentation switches and several driving switches are integrated on said integrated circuit.
- the first alimentation switch is directly connected to first driving switch.
- a second alimentation switch being between on the one side a point between first alimentation switch and first driving switch and on the other side fourth external connection.
- two driving switches of a DCDC buck battery charger being between first external connection and fourth external connection.
- a chip including a package including an integrated circuit according to some embodiments of the invention.

A third object of the invention is achieved with a mobile equipment, comprising a processing system, a battery, an external connection, a DCDC buck converter, including one or more driving switches and being adapted to transmit, to processing system, alimentation power when coming from battery and when coming from external connection, at least one or more alimentation switches adapted to switch coming alimentation power between battery and external connection, wherein at least one alimentation switch and at least one driving switch are integrated on a single integrated circuit.

A fourth object of the invention is achieved with a mobile equipment, comprising a first processing system, an external connection adapted to be connected to an external power source, a battery, a DCDC buck converter, including two driving switches driving a self and a capacitor, a first alimentation switch, a second alimentation switch, an alimentation switch controller adapted to work at least in a first mode and in a second mode, connected together in such a way that : in a first mode, first alimentation switch is closed, second alimentation switch is open, external connection provides power alimentation to first processing system via the DCDC buck converter, battery cannot provide power alimentation to first processing system, in a second mode, first alimentation switch is open, second alimentation switch is closed, battery provides power alimentation to first processing system via the DCDC buck converter, external connection cannot provide power alimentation to first processing system, wherein first alimentation switch and the two driving switches of the DCDC buck converter are integrated on a single integrated circuit.

Preferred embodiments comprise one or more of the following features:
- the only alimentation switch or all alimentation switches on the one side and the only driving switch or all driving switches on the other side are integrated on said single integrated circuit.
- a DCDC buck battery charger adapted to charge the battery from external connection, at least in first mode.
- the DCDC buck battery charger and the DCDC buck converter are connected in parallel to each other.
- DCDC buck battery charger includes two driving switches driving a self and a capacitor, and wherein the two driving switches of the DCDC buck battery charger are integrated on said single integrated circuit.
- second alimentation switch is integrated on said single integrated circuit.
- mobile equipment is an electronic tablet.
- a power alimentation managing method in a mobile equipment according to some embodiments of the invention, wherein the method includes: an external alimentation mode where mobile equipment is set in first mode and where an external power source is connected to external connection, an alternative internal alimentation mode where mobile equipment is set in second mode and where no external power source is connected to external connection.

According to some embodiments of the invention, battery is a multiple cell battery.

According to some embodiments of the invention, not only driving switches and alimentation switches are integrated, but also power transistors of power stage of DCDC buck converter and / or of DCDC buck battery charger.

According to some embodiments of the invention, the integrated circuit further integrates an alimentation switch controller adapted to control alimentation switch(es) integrated on integrated circuit.

According to some embodiments of the invention, the DCDC buck battery charger is directly connected to external connection of mobile equipment without any switch in between.

Further features and advantages of the invention will appear from the following description of embodiments of the invention, given as non-limiting examples, with reference to the accompanying drawings listed hereunder.

### BRIEF DESCRIPTION OF THE DRAWINGS

Fig. 1 shows an example of a part of the architecture of a mobile equipment according to first prior art.
Fig. 2 shows an example of a part of the architecture of a mobile equipment according to third prior art.
Fig. 3 shows an example of a part of the architecture of a mobile equipment according to an embodiment of the invention.
Fig. 4 shows a detailed example of a part of the architecture of a mobile equipment according to an embodiment of the invention.
Fig. 5 shows an example of switching between two different alimentation modes that can be performed with the architecture of a mobile equipment according to an embodiment of the invention.

### DETAILED DESCRIPTION OF THE INVENTION

A preferred example of mobile equipment according to some embodiments of the invention is an electronic tablet. The tablet market is new and the tablet power needs are relatively close to the power needs of a laptop. But tablet keeps still less with high current peaks for some duration that cannot be compensated by capacitors. Furthermore, the tablet should be used connected the power grid for a long time and must be used as a mobile equipment when it is not connected to the power grid.

Tablet is a new device which on the one side tends to use components developed for the mobile phone industry mainly, that is to say developed for a one cell battery, and on the other side tends to present architecture close to the laptop architecture.

The architecture proposed according to some embodiments of the invention tries and gives a way to manage easily a higher voltage source to supply the power alimentation management for the processor or processing system. This architecture integrates on the same integrated circuit the driving switches of a DCDC buck converter and the alimentation switches. This architecture thereby presents high power alimentation flexibility while keeping a relatively small size.

The DCDC buck charger will remain connected to the external source to provide the energy to the battery, while the processing system is power alimented by the external source through the DCDC buck converter.

External connections will sometimes be called nodes and vice-versa, depending on what aspect is considered, the fact that they can be connected to something external or the fact that several electrical wires arrive to them.

Fig. 3 shows an example of a part of the architecture of a mobile equipment according to an embodiment of the invention. An external source 1 is connected to mobile equipment through an external connection 10. Mobile equipment includes a power alimentation managing system 2B, a first processing system 8 working under a voltage V1, a second processing system 9 working under a voltage V2, a battery 7. Battery 7 is connected to power alimentation managing system 2B through external connection 70. First processing system 8 is connected to power alimentation managing system 2B through external connection 80. Second processing system 9 is connected to power alimentation managing system 2B through external connection 90.

Power alimentation managing system 2B comprises a first alimentation switch 11, a second alimentation switch 12, an alimentation switch controller 5, a DCDC buck converter 4, a DCDC buck battery charger 6. Power path 3 includes first alimentation switch 11, second alimentation switch 12, alimentation switch controller 5, and DCDC buck converter 4. Only control part and preferably power transistors of power stage of a DCDC buck converter 4 without the associated self and capacitor and only control part and preferably power transistors of power stage of a DCDC buck battery charger 6 without the associated self and capacitor are integrated on same integrated circuit included in power alimentation managing system 2B. DCDC buck battery charger 6 includes a DCDC buck converter with specific state machine that can control this DCDC buck converter to charge a battery with a Constant Current/Constant Voltage algorithm, so-called CCCV charger.

Alimentation switch controller 5 is connected to first and second alimentation switches 11 and 12, in such a way that either first alimentation switch 11 is closed and second alimentation switch is open or first alimentation switch 11 is open and second alimentation switch is closed. First alimentation switch 11 and DCDC buck converter 4 are connected in series between external connection 10, which is external to power alimentation managing system 2B and external to mobile equipment, and external connection 80, which is, as external connections 70 and 90, indeed external to power alimentation managing system 2B but internal to mobile equipment. There is a node 13 between first alimentation switch 11 and DCDC buck converter 4. Second alimentation switch 12 is connected between node 13 and external connection 70. DCDC buck battery charger 6 is between external connection 10 and external connection 70.

In an external alimentation mode, first alimentation switch 11 is closed and second alimentation switch is open, an external source 1 is connected to external connection 10. First processing system 8 is power alimented by external source 1 through DCDC buck converter 4, whereas battery 7 is charged by external source 1 through DCDC buck battery charger 6. At the same time second processing system 9 is directly, that is to say without going through DCDC buck converter 4, power alimented by external source 1.

In a more detailed way, mobile equipment is connected to the external source 1. First alimentation switch 11 is closed, the current through alimentation switch 11 feeds the DCDC buck converter 4 providing the low voltage to the processing system 8. Second alimentation switch 12 is open and blocks any current from the external source 1 to the battery 7. This second alimentation switch 12, when closed, can let the current flowing from the battery 7 to the processing systems 8 and 9 in case of the external source 1 not being able to sustain the current drawn by the mobile equipment or when the external source 1 is disconnected from the mobile equipment. In case of the external source 1 not being able to sustain the current drawn by the mobile equipment, second alimentation switch 12 is closed and first alimentation is open, the mobile equipment is then supplied by the battery 7, in order to avoid oscillations due to an external source 1 voltage dropping caused by a lack of current capability; control part of the DCDC buck converter 4 may then test with a regular timing the capability of the external source 1 to supply again correctly the mobile equipment. DCDC buck converter 4 is running with an output voltage correctly regulated to the defined output voltage value. DCDC buck battery charger 6 charges the battery 7 with the predefined value but when the switch controller 5 and the processing system 8 are alive, the DCDC buck battery charger 6 can be disconnected by the alimentation switches 11 and 12. The DCDC buck battery charger 6 can modulate the current charge in function of the different parameters to let the mobile equipment running in a safe area in term of power dissipation. The DCDC buck battery charger 6 can be off when the battery 7 is fully charged or when the power dissipation is too big to continue to charge the battery 7. In those cases, the system is still correctly supplied by the external source 1 through the power path structure including first alimentation switch and DCDC buck converter 4.

In an internal alimentation mode, first alimentation switch 11 is open and second alimentation switch 12 is closed, no external source 1 is connected to external connection 10. First processing system 8 is power alimented by battery 7 through DCDC buck converter 4, whereas DCDC buck battery charger 6, being disconnected from external source, if off, because it has no power from external source to transmit to battery 7. At the same time, second processing system 9 is directly, that is to say without going through DCDC buck converter 4, power alimented by battery 7.

In a more detailed way, mobile equipment is running on the battery 7. When the external source 1 is not present, the second alimentation switch 12 is closed and battery 7 supplies the whole mobile equipment. The first alimentation switch 11 is then open. DCDC buck converter 4 is then fed by the battery 7 through second alimentation switch 12 and supplies the mobile equipment properly when the output voltage of the battery 7 is in the correct range. DCDC buck battery charger 6 is off. When the external source 1 is connected, the mobile equipment could be supplied by the battery 7 if the external source 1 cannot provide enough energy for a while, the second alimentation switch 12 can let some current flowing into it to let the external source 1 output voltage going above the battery 7 output voltage and afterwards, the mobile equipment will be supplied by the external source 1.

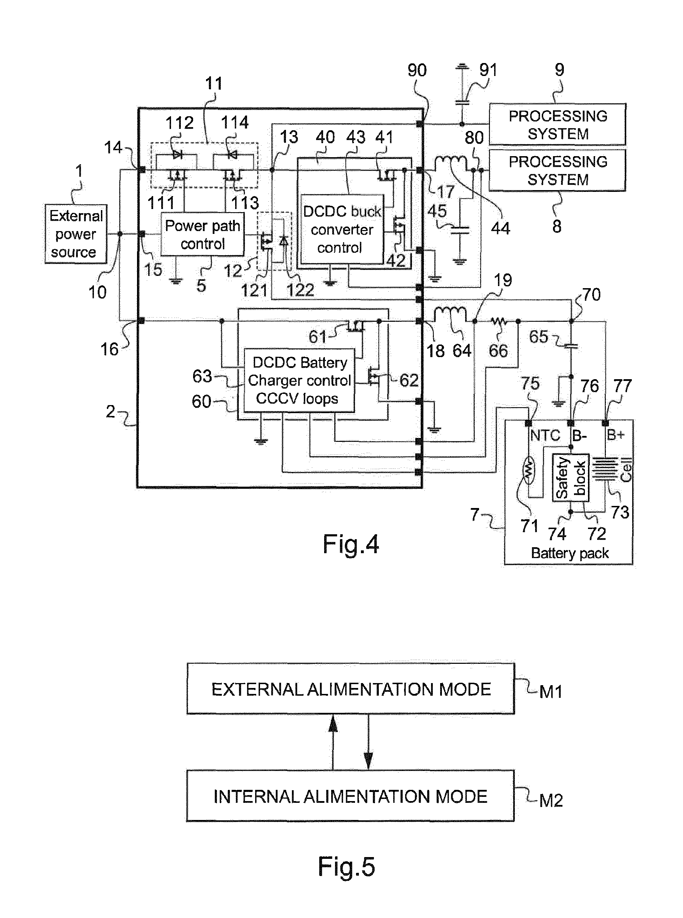

On figure 3, we can see high integration of alimentation switches 11 and 12, together with their alimentation switch controller 5, and together with control parts of DCDC buck converter 4 and of DCDC buck battery charger 6. More details about such integration will be shown on figure 4.

First voltage V1 of first processing system 8 can be around 3.6 Volts. First voltage V1 of first processing system 8 corresponds to output voltage of DCDC buck converter 4 which can be programmable. First processing system 8 can be the central processor of mobile equipment.

Second voltage V2 of first processing system 8 can be around 8.4 or 12.6 Volts or more, depending on the number of cells of battery 7, one cell providing for example 4.2 Volts in Lithium Ion technology or in Lithium polymer technology. Second processing system 9 can include other processors of mobile equipment concerning other functions of mobile equipment. Such functions can deal with audio amplifier, backlight driver, Radio Frequency power amplifier, and so on.

Alimentation switches can also be used to perform other functions. For example, they can manage the DCDC buck battery charger 6 current limitation when the temperature of the device increases dangerously due to too high power dissipation into the integrated circuit.

Fig. 4 shows a detailed example of a part of the architecture of a mobile equipment according to an embodiment of the invention. The running phases are the same as on figure 3. First processing system 8 and second processing system 9 are power alimented either by external source 1 when it is connected to mobile equipment or by battery 7.

External connection 10 connects external source 1 to mobile equipment, and more precisely to integrated circuit 2. External connection 10 is connected to first alimentation switch 11 through input connection 14, to alimentation switch controller 5 through input connection 15, to DCDC buck battery charge 6 through input connection 16.

Alimentation switch controller 5 will then be connected to the external source 1 through external connection 10. Alimentation switch controller 5 may integrate an input voltage detection mechanism allowing for detecting a good external power source. Alimentation switch controller 5 may further integrate a current measuring system in order to get the current coming from the external source 1. Measuring this current allows for limiting the current drawn into the battery charger in order to limit the possibility for the external source 1 voltage to drop.

In an alternative embodiment not shown on figure 4, the DCDC buck battery charge 6 input may be connected to the node 13, after first alimentation switch 11. In this alternative embodiment, the DCDC buck battery charge 6 input would be better protected thanks to over voltage control, whereas there would be an noticeable increase in power dissipation which would then have to be taken into account.

Node 13 is between first alimentation switch 11 and DCDC buck converter control part 40. Node 13 is linked to second processing system 9 through connection 90. From connection 90, a capacitor 91, in parallel to second processing system 9, goes to the ground. Between output connection 17 of DCDC buck converter control part 40 and node 80, there is self 44 of DCDC buck converter. From node 80, a capacitor 45 of DCDC buck converter, parallel to first processing system 8, goes to the ground.

Second alimentation switch is between node 13 and node 70. From node 70, at least a capacitor 65 of DCDC buck battery charger, in parallel to battery 7, goes to the ground. Between output connection 18 of DCDC buck converter control part 40 and node 19, there is self 64 of DCDC buck battery charger, and between node 19 and node 70, there is an optional resistance 66.

Battery 7 presents three connections 75, 76 and 77. Connection 77 is connected to node 70. Connection 76 goes to the ground. Connection 75 is connected to DCDC buck battery charger control part 60. Inside battery 7, there is an internal node 74. Between connection 75 and connection 76, there is a thermal resistance 71. Between connection 76 and internal node 74, there is a safety block 72. Between connection 77 and internal node 74, there are the cells 73 of battery 7 which are in series of each other or of one another.

First alimentation switch 11 includes two transistors 111 and 113 and two diodes 112 and 114. Second alimentation switch 12 includes a transistor 121 and a diode 122. Alimentation switch controller 5 is connected to input connection 15, to transistor 111 gate, to transistor 113 gate, to transistor 121 gate, and to the ground. Of course, integrated circuit may include other usual elements like internal clock, internal biasing, internal reference, internal power supply running either on the battery or on the external source.

Between node 13 and node 17, there is DCDC buck converter control part 40. DCDC buck converter control part 40 includes a first driving switch 41 which is a transistor, a second driving switch 42 which is a transistor, a controller 43. First driving switch 41 is between node 13 and node 17. Second driving switch 42 goes from node 17 to the ground. Controller 43 is connected to node 80, to transistor 41 gate, to transistor 42 gate, and to the ground. Node 80 is a voltage node used for regulated voltage measurement.

Between input connection 16 and output connection 18, there is DCDC buck battery charger control part 60. DCDC buck battery charger control part 60 includes a first driving switch 61 which is a transistor, a second driving switch 62 which is a transistor, a controller 63. First driving switch 61 is between node 16 and node 18. Second driving switch 62 goes from node 18 to the ground. Controller 63 is connected to node 16, to node 19, to node 70, to battery connection 75, to transistor 61 gate, to transistor 62 gate, and to the ground. Node 70 is a node used for voltage and current sensing.

Alimentation switches 11 and 12, driving switches 41, 42, 61 and 62, alimentation switch controller 5, DCDC buck converter controller 43, DCDC buck battery charger controller 63 are all integrated on same single integrated circuit 2. Integrated circuit 2 is preferably included in a single package to constitute a single chip. Therefore, for both preceding reasons, size of mobile equipment is reduced.

DCDC buck converter control part 40 and DCDC buck battery charger control part 60 can be done with only NMOS transistors. The power path including alimentation switches 11 and 12 can be done with NMOS transistors or with PMOS transistors. The first alimentation switch 11 is done with a back to back architecture because the mobile equipment is switched from a battery voltage to an external source voltage and any conflict is then avoided. So, the first alimentation switch 11 is switched off when the external source 1 is disconnected. The second alimentation switch 12 coming from the battery 7 could be connected to the input of the DCDC buck battery charger to limit the number of external pins. The sense resistor 66 at the output of the DCDC buck battery charger is optional because the current measurement can be done internally to the DCDC buck battery charger, depending on the current accuracy needed. The temperature could be controlled by another part of the mobile equipment and the information could be sent to the DCDC buck battery charger by a communication bus. The temperature could be controlled by the control part of the DCDC buck battery charger via a dedicated pin which is connected to node 75 of battery 7.

Fig. 5 shows an example of switching between two different alimentation modes that can be performed with the architecture of a mobile equipment according to an embodiment of the invention. This switching is part of a power path managing method in a mobile equipment and is a switching between an external alimentation mode Ml and an internal alimentation mode M2.

In external alimentation mode M1, mobile equipment is set in first mode and external power source 1 is connected to external connection 10. In first mode of mobile equipment, first alimentation switch 11 is closed and second alimentation switch 12 is open. External connection 10 provides power alimentation to first processing system 8 via the DCDC buck converter 4. Battery 7 cannot provide power alimentation to first processing system 8.

In alternative internal alimentation mode M2, mobile equipment is set in second mode and no external power source 1 is connected to external connection 10. In second mode of mobile equipment, first alimentation switch 11 is open, second alimentation switch 12 is closed. Battery 7 provides power alimentation to first processing system 8 via the DCDC buck converter 4. External connection 10 cannot provide power alimentation to first processing system 8.

The invention has been described with reference to preferred embodiments. However, many variations are possible within the scope of the invention.

## Claims

1. Integrated circuit adapted to perform power path control in a mobile equipment, integrating:
- external connections (10, 70, 80, 90),
- one or more alimentation switches (11, 12) adapted to switch on or off one or more external connections (10, 70),
wherein said printer circuit board further integrates one or more driving switches (41, 42) of at least one DCDC buck converter (4),
and wherein one side (13) of one driving switch (41) is connected both to one external connection (10) through an alimentation switch (11) and to another external connection (70) directly or through an alimentation switch (12).

2. Integrated circuit according to claim 1, wherein several alimentation switches (11, 12) and several driving switches (41, 42) are integrated on said integrated circuit.

3. Integrated circuit adapted to perform power path control in a mobile equipment, integrating:
- a first external connection (10),
- a second external connection (80),
- a third external connection,
- a first alimentation switch (11),
- two driving switches (41, 42) of a DCDC buck converter (4),
the first alimentation switch (11) and first driving switch (41) being successively connected in series between first external connection (10) and second external connection (80),
second driving switch (42) being connected between first driving switch (41) and third external connection,
the first driving switch (41) being connected to first alimentation switch (11) without any self in between and being connected to a fourth external connection (70) directly or through an alimentation switch (12).

4. Integrated circuit according to claim 3, wherein the first alimentation switch (11) is directly connected to first driving switch (41).

5. Integrated circuit according to claim 3 or 4, further integrating a second alimentation switch (12) being between on the one side a point (13) between first alimentation switch (11) and first driving switch (41) and on the other side fourth external connection (70).

6. Integrated circuit according to claim 5, further integrating two driving switches (61, 62) of a DCDC buck battery charger (6) being between first external connection (10) and fourth external connection (70).

7. Chip including a package including an integrated circuit (2) according to any of preceding claims.

8. Mobile equipment, comprising:
- a processing system (8),
- a battery (7),
- an external connection (10),
- a DCDC buck converter (4), including one or more driving switches (41, 42) and being adapted to transmit, to processing system (8), alimentation power when coming from battery (7) and when coming from external connection (10),
- at least one or more alimentation switches (11, 12) adapted to switch coming alimentation power between battery (7) and external connection (10),
wherein at least one alimentation switch (11, 12) and at least one driving switch (41, 42) are integrated on a single integrated circuit (2).

9. Mobile equipment according to claim 8, wherein the only alimentation switch or all alimentation switches (11, 12) on the one side and the only driving switch or all driving switches (41, 42) on the other side are integrated on said single integrated circuit (2).

10. Mobile equipment, comprising:
- a first processing system (8),
- an external connection (10) adapted to be connected to an external power source,
- a battery (7),
- a DCDC buck converter (4), including two driving switches (41, 42) driving a self (44) and a capacitor (45),
- a first alimentation switch (11),
- a second alimentation switch (12),
- an alimentation switch controller (5) adapted to work at least in a first mode and in a second mode,
connected together in such a way that:
- in a first mode, first alimentation switch (11) is closed, second alimentation switch (12) is open, external connection (10) provides power alimentation to first processing system (8) via the DCDC buck converter (4), battery (7) cannot provide power alimentation to first processing system (8),
- in a second mode, first alimentation switch (11) is open, second alimentation switch (12) is closed, battery (7) provides power alimentation to first processing system (8) via the DCDC buck converter (4), external connection (10) cannot provide power alimentation to first processing system (8),
wherein first alimentation switch (11) and the two driving switches (41, 42) of the DCDC buck converter (4) are integrated on a single integrated circuit (2).

11. Mobile equipment according to claim 10, further comprising a DCDC buck battery charger (6) adapted to charge the battery (7) from external connection (10), at least in first mode.

12. Mobile equipment according to claim 11, wherein the DCDC buck battery charger (6) and the DCDC buck converter (4) are connected in parallel to each other.

13. Mobile equipment according to claim 11 or 12, wherein DCDC buck battery charger (6) includes two driving switches (61, 62) driving a self (64) and a capacitor (65), and wherein the two driving switches (61, 62) of the DCDC buck battery charger (6) are integrated on said single integrated circuit (2).

14. Mobile equipment according to any of claims 10 to 13, wherein second alimentation switch (12) is integrated on said single integrated circuit (2).

15. Mobile equipment according to any of claims 8 to 14, wherein mobile equipment is an electronic tablet.

16. Power alimentation managing method in a mobile equipment according to any of claims 10 to 14, wherein the method includes:
- an external alimentation mode (M1) where mobile equipment is set in first mode and where an external power source (1) is connected to external connection (10),
- an alternative internal alimentation mode (M2) where mobile equipment is set in second mode and where no external power source is connected to external connection (10).
